# EUROPEAN PATENT SPECIFICATION

(11) **EP 3 230 489 B1**
(45) Date of publication and mention of the grant of the patent: **15.02.2023**
(21) Application number: 15823861.8
(22) Date of filing: 11.12.2015
(51) Int. Cl.: C23C 14/12, C23C 14/24, C23C 14/22, H01L 51/00, H01L 51/42

(54) **ORGANIC VAPOR PHASE DEPOSITION SYSTEM AND METHODS OF USE FOR SIMULTANEOUS DEPOSITION OF LOW AND HIGH EVAPORATION TEMPERATURE MATERIALS, AND DEVICES PRODUCED THEREIN**
SYSTEM ZUR ORGANISCHEN DAMPFPHASENABSCHEIDUNG UND VERFAHREN ZUR VERWENDUNG ZUR GLEICHZEITIGEN ABSCHEIDUNG VON MATERIALIEN MIT NIEDRIGER UND HOHER VERDAMPFUNGSTEMPERATUR UND DARIN HERGESTELLTE VORRICHTUNGEN
SYSTÈME DE DÉPÔT EN PHASE VAPEUR ORGANIQUE ET PROCÉDÉ D'UTILISATION PERMETTANT LE DÉPÔT SIMULTANÉ DE MATÉRIAUX À TEMPÉRATURES D'ÉVAPORATION BASSE ET ÉLEVÉE ET APPAREILLAGES PRODUITS EN SON SEIN

(30) Priority: 11.12.2014 US 201462090665 P
(43) Date of publication of application: 18.10.2017
(73) Proprietor: The Regents Of The University Of Michigan, Ann Arbor, Michigan 48109 (US)
(72) Inventor: FORREST, Stephen, R., Ann Arbor, MI (US); SONG, Byeongseop, Ann Arbor, MI 48105 (US)
(74) Representative: Finnegan Europe LLP
(86) International application number: PCT/US2015/065163
(87) International publication number: WO 2016/094755

(56) References cited:
- US-A1- 2009 165 859
- SHTEIN MAX ET AL: "Material transport regimes and mechanisms for growth of molecular organic thin films using low-pressure organic vapor phase deposition", JOURNAL OF APPLIED PHYSICS, AMERICAN INSTITUTE OF PHYSICS, US, vol. 89, no. 2, 15 January 2001 (2001-01-15), pages 1470-1476, XP012052809, ISSN: 0021-8979, DOI: 10.1063/1.1332419 cited in the application

## Description

The present disclosure is directed to organic vapor phase deposition system and methods of use for simultaneous deposition of low and high evaporation temperature materials, and devices produced with said systems.

Organic vapor phase deposition (OVPD) has been developed in organic thin-film growth as an analogous process to chemical vapor deposition. For reference, successful demonstrations of OVPD as an alternative technique to deposit organic films are described in "Organic Vapor Phase Deposition: A New Method for the Growth of Organic Thin Films with Large Optical Non-Linearities" by Burrows *et al,* and in "Organic Vapor Phase Deposition" by Baldo *et al* ([1] J. L. F. P.E. Burrows, S.R. Forrest, L.S. Sapochak, J. Schwartz, P. Fenter, T. Buma, V.S. Ban, J. Cryst. Growth 1995, 156, 91.; [2] M. Baldo, M. Deutsch, P. Burrows, H. Gossenberger, M. Gerstenberg, V. Ban, S. Forrest, Adv. Mater. 1998, 10, 1505.) OVPD utilizes a stream of hot inert carrier gas to transport organic source vapor towards cooled substrate, and the material transport mechanism in OVPD systems was rigorously revealed by simulation and experimental data in the following references: [2]M. Baldo, M. Deutsch, P. Burrows, H. Gossenberger, M. Gerstenberg, V. Ban, S. Forrest, Adv. Mater. 1998, 10, 1505. [3] M. Shtein, H. F. Gossenberger, J. B. Benziger, S. R. Forrest, J. Appl. Phys. 2001, 89, 1470. [4] M. Shtein, P. Peumans, J. B. Benziger, S. R. Forrest, J. Appl. Phys. 2003, 93, 4005 as well as in patent document US 2009/165859 A1.

The above references determined that a stagnant boundary layer formed near cooled substrate in OVPD, due to a relatively high growth pressure from the background carrier gas, which is where the molecular interaction of organic material occurs.

An initial step of an OVPD sequence is injection of organic vapor into the main reactor of an OVPD system that is heated to a temperature that is at least as hot as the evaporation temperature of all the organic materials used in the system. Additional descriptions of OVPD systems are described in the above cited references. The main reactor should maintain a higher temperature than evaporation temperature of all the organic materials used in the system in order to eliminate any possible condensation on the wall of the main reactor. This temperature requirement of main reactor prevents cross-contamination of organic materials during subsequent OVPD sequences, which in turn makes the maintenance of the OVPD system easier compared to vacuum thermal evaporation (VTE), which is an alternative technique.

However, this temperature restriction brings about limited material choices for situations where it would be desirable for more than one material to be evaporated simultaneously in the OVPD system. Low evaporation-temperature materials (LTM) experience thermal degradation or decomposition when LTM travel through a reactor with an elevated temperature required by high evaporation-temperature material (HTM). There is no such issue in VTE because each source material can be heated separately and VTE proceeds in a high vacuum (-10-7 torr). For these reasons, OVPD has been used mostly in laboratory-scale even though it shows outstanding advantages over VTE in terms of device performance, scalability, and material utilization efficiency, through superior control over the morphology of deposited organic films, as described by B. Song et al. in Adv. Matter (2014, 26, 2914), R. R. Lunt et al. in Appl. Phys. Lett. (2009, 95, 233305), and by M. Schwambera et al. in SID Symp. Dig. Tech. Pap. (2003, 34, 1419).

The invention is directed to an organic vapor phase deposition system as defined by claims 1 and 7 and corresponding methods of claims 11 and 15 respectively.

In some embodiments, the temperature of the at least two source barrels may be independently controlled. In some embodiments, the temperature of the at least two source barrels may be controlled by heating coils surrounding at least a portion of the source barrels. The at least one carrier gas injection line is ring shaped and extends concentric to the main reactor wall. In some embodiments, the at least one carrier gas injection line may discharge a carrier gas, which includes at least one of Argon gas and Nitrogen gas. In some embodiments, one of the source barrels may be configured to be controlled to a temperature of about 200°C and another one of the source barrels may be configured to be controlled to a temperature of about 500°C while the main reactor may be configured to be controlled to a temperature of about 300°C. In some embodiments, the organic vapors may be introduced into the main reactor at about 20 sccm while the carrier gas is distributed into the main reactor at about 20 sccm. In some embodiments, the at least one carrier gas injection line may begin distributing the carrier gas along the main reactor wall above where the two organic vapors are introduced into the main reactor. In some embodiments, the system may be configured in a vertical orientation where the organic vapors are introduced into the main reactor above the substrate stage.

In another aspect, set forth in claim 7, the present invention is directed to an organic vapor phase deposition system that includes a main reactor and a first source barrel configured to introduce a first organic vapor into a first end of the main reactor. The system also includes a substrate stage positioned at a second end of the main reactor and a second source barrel configured to distribute a second organic vapor, which is at a lower temperature than the second organic vapor, into the main reactor through a second source barrel outlet. The second source barrel outlet is positioned between the first end of the main reactor and the substrate stage a distance from the substrate, wherein the distance is selected to minimize the exposure of the first organic vapor to the higher temperature of the second organic vapor as the first organic vapor travels toward the substrate stage.

In some embodiments, the at least one source barrel outlet may be shower-head ring shaped and configured to distribute the second organic vapor toward the substrate. In some embodiments, the system may include an insulating plate positioned on the opposite side of the second source barrel outlet than the substrate stage. In some embodiments, the first organic vapor may be configured to be introduced into the main reactor at a temperature of about 200°C and the second organic vapor may be configured to be distributed into the main reactor at a temperature of about 500°C while a substrate on the substrate stage may be at a temperature of about 30°C.

The invention is directed also to a method of fabricating an organic film using organic vapor phase deposition, as defined in claim 11. The method includes introducing a first organic vapor at a first temperature into a main reactor defined by a perimeter wall and introducing a second organic vapor at a second temperature, which is greater than the first temperature, into the main reactor and distributing a carrier gas into the main reactor along an inner surface of the perimeter wall. The carrier gas is configured to reduce condensation of the second organic vapor on the perimeter wall as the first organic vapor and the second organic vapor flow through the main reactor toward a substrate.

In some embodiments, the first temperature may be about 200°C, the second temperature may be about 500°C, and a main reactor temperature may be about 300°C. In some embodiments, the method may also include independently controlling the first organic vapor to the first temperature and the second organic vapor to the second temperature using heating coils surrounding a first source barrel and a second source barrel. In some embodiments, the carrier gas includes at least one of Argon gas and Nitrogen gas. In some embodiments, the first organic vapor and the second organic vapor are each introduced into the main reactor at about 20 sccm while the carrier gas is distributed into the main reactor at about 20 sccm. In some embodiments, distributing the carrier gas begins above where the first organic vapor and the second organic vapor are introduced into the main reactor. In some embodiments, the carrier gas is distributed from a ring that extends around the main reactor.

In another aspect, the present invention is directed to a method of fabricating an organic film using organic vapor phase deposition, as set forth in claim 15. The method includes introducing a first organic vapor at a first temperature into a first end of a main reactor and directing the first organic vapor toward a substrate positioned at a second end of the main reactor and introducing a second organic vapor at a second temperature, which is greater than the first temperature, into the main reactor toward the substrate. The second organic vapor is introduced into the main reactor between the first end of the main reactor and the substrate a distance from the substrate, wherein the distance is selected to minimize the exposure of the first organic vapor to the higher temperature of the second organic vapor as the first organic vapor travels toward the substrate.
Fig. 1A is a plot of refractive indexes (n) vs. wavelength of DTDCPB and C₇₀ grown by VTE or OVPD.
Fig. 1B is a plot of extinction coefficients (k) vs. wavelength of DTDCPB and C₇₀ grown by VTE or OVPD.
Fig. 2A is a plot of current density vs. voltage of dark *J-V* characteristics of DTDCPB:C₇₀ mixed heterojunction device whose active layers were grown by either VTE or OVPD.
Fig. 2B is a plot of current density vs. voltage of *J*-*V* characteristics of the same devices as Fig. 2A under simulated AM 1.5G illumination.
Fig. 3A is a schematic of a horizontal OVPD system.
Fig. 3B is a photograph of a horizontal OVPD system.
Fig. 3C is a schematic of a vertical OVPD system, according to an exemplary embodiment.
Fig. 4A shows a numerical simulation that displays the temperature distribution of the vertical OVPD system of Fig. 3C.
Fig. 4B shows a numerical simulation that displays the isosurface plot of temperature of the vertical OVPD system of Fig. 3C.
Fig. 4C shows a numerical simulation that displays the concentration of low evaporation temperature material (LTM) for the vertical OVPD system of Fig. 3C.
Fig. 4D shows a numerical simulation that displays the concentration of high evaporation temperature material (HTM) for the vertical OVPD system of Fig. 3C.
Fig. 5A, is a schematic of a Gen-6 OVPD system used in large-area device fabrication.
Fig. 5B shows a photograph of the system of Fig. 5A.
Fig. 5C shows a top view and section view of an OVPD system, according to an exemplary embodiment.
Fig. 6A shows a numerical simulation of the temperature distribution inside the chamber of the OVPD system of Fig. 5C.
Fig. 6B shows a numerical simulation of the isosurface of temperature inside the chamber of the OVPD system of Fig. 5C.
Fig. 6C shows a numerical simulation of the concentration of LTM inside the chamber of the OVPD system of Fig. 5C.
Fig. 6D shows a numerical simulation of the concentration of HTM inside the chamber of the OVPD system of Fig. 5C.

The following acronyms are utilized in the following description: OVPD: Organic vapor phase deposition; HTM: High-temperature evaporation material; LTM: Low-evaporation temperature material; DTDCPB: 2-[(7-{ 4-[N,N-Bis(4-methylphenyl)amino]phenyl}-2,1,3-benzothiadiazol-4-yl)methylene]propanedinitrile; Bphen: Bathophenanthroline; ITO: Indium Tin Oxide; VTE: Vacuum Thermal Evaporation.

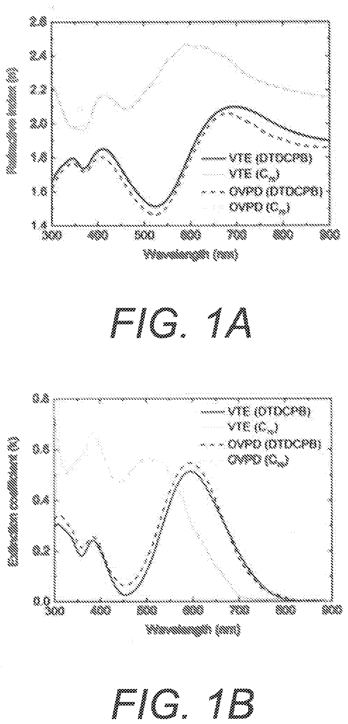

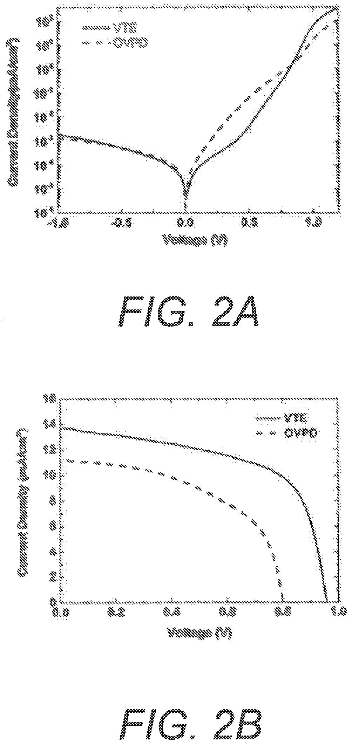

Figs. 1A, 1B, 2A and 2B show plots related to devices fabricated without the principles of the present disclosure and demonstrate the deleterious effects of high temperature on LTM during fabrication in an OVPD reactor, as compared to equivalent devices fabricated in a VTE reactor. DTDCPB and C₇₀ were evaporated at 200±2°C, and 480±2°C, respectively, in a furnace configured with three zones, each zone was independently set at 420°C, 480°C, and 540°C. Figs. 1A and 1B show optical constants determined with variable-angle spectroscopy ellipsometry of 20 nm thick organic thin films of each material.

The refractive index of Fig. 1A and extinction coefficient of Fig. 1B of the DTDCTB material evaporated in OVPD differ by a maximum of 6±2 % compared to the same material evaporated in VTE. In contrast, C₇₀, which is a HTM, shows identical optical properties for both growth techniques.

A mixed heterojunction device with DTDCPB:C₇₀ was fabricated with the following structure: ITO/MoO3 (10 nm)/1:1 (by vol.) DTDCTB:C₇₀ (80 nm)/1:1 (by vol.) Bphen:C60 (8 nm)/Bphen (5 nm)/Ag (100 nm). DTDCTB:C₇₀ active layers were grown by VTE and OVPD. DTDCPB:C₇₀ were co-evaporated at 200±2°C, and 480±2°C, respectively to reach deposition rates of 0.5Å/s, which provides a 1:1 volume ratio. 10 sccm (standard cubic centimeters per minute) N₂ flow was used in each source barrel along with 6 sccm dilution flow, leading to 0.28 torr of chamber pressure using the system configuration described in the above reference by Baldo *et al.* The substrate was water-cooled to *TTss* = 25°C.

Also disclosed is an organic photovoltaic device comprising an organic film, wherein the organic film comprises low evaporation temperature material and high evaporation temperature material and the organic film is deposited by an organic vapor phase deposition system configured to separate LTM from high temperatures in the main reactor and separate HTM from low temperature surfaces aside from the substrate. The organic photovoltaic device may comprise the components and layers as described above. Other embodiments of the present disclosure will be apparent to those skilled in the art from consideration of the specification and practice of the present disclosure herein.

Figs. 2A and 2B contrasts the dark and light J-V characteristics of the samples in Figs. 1A and 1B. Fig. 2A shows the dark J-V characteristics of DTDCPB:C₇₀ samples prepared by OVPD and VTE. Series resistance Rs, determined from Fig. 2A, were 0.36±0.05, 1.29±0.09 Ω·cm² for VTE, and OVPD-grown devices, respectively.

The low conductivity (and high resistance) of the DTDCPB:C₇₀ sample grown with OVPD is speculated to be from the thermal degradation of the DTDCTB molecule after the molecule evaporated inside the hot reactor in OVPD. Measured device efficiency of the OVPD-grown sample under 1 sun illumination is 4.7±0.2 %, which is significantly lower than the equivalent VTE-grown device, 8.0±0.2 %.

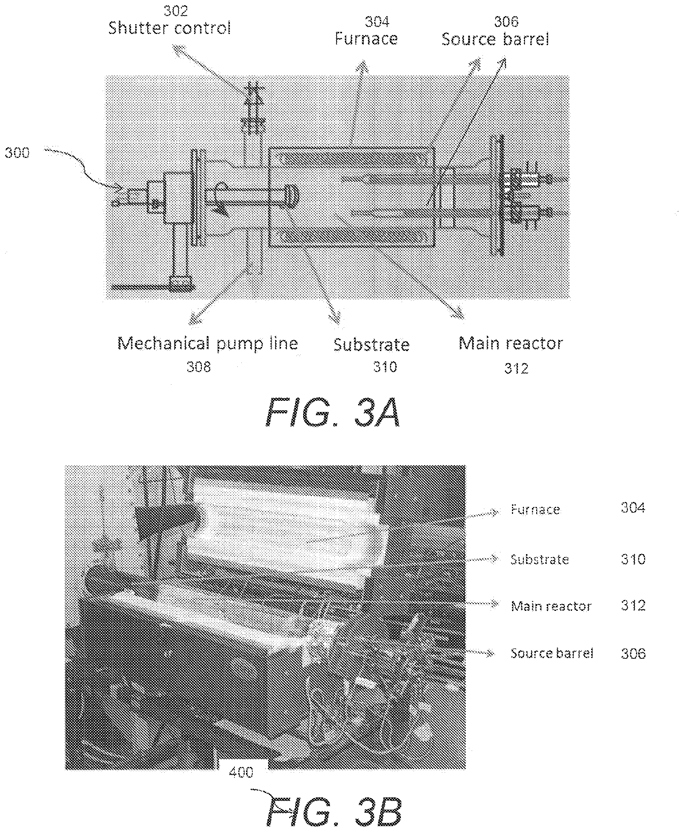

Figs. 3A and 3B show a schematic and photograph of a horizontal OVPD system 300. OVPD system 300 includes a quartz tube for the main reactor vessel 312, source barrels 306 (e.g., a first source barrel and a second source barrel), a substrate or substrate stage 310, a shutter 302, and a mechanical pump 308. OVPD system 300 is configured such that the main reactor 312 may be surrounded by a furnace 304 with three heating zones, each source barrel 306 may have an inert carrier gas injection line configured to control the flow of carrier gas through each source barrel 306, and the substrate stage 310 may be attached to a water line to adjust the substrate temperature. The OVPD system 300 is configured such that the temperatures of each source barrel 306 may be controlled by adjusting the position of an organic source inside the furnace 304. Based on this configuration, the temperature of furnace 304 should be at least as high as the evaporation temperature of the HTM to ensure that there is no condensation on the wall of the main reactor 312 tube. In such a configuration, the LTM vapors are exposed to the high temperature zone required by HTM, causing the degradation of the LTM.

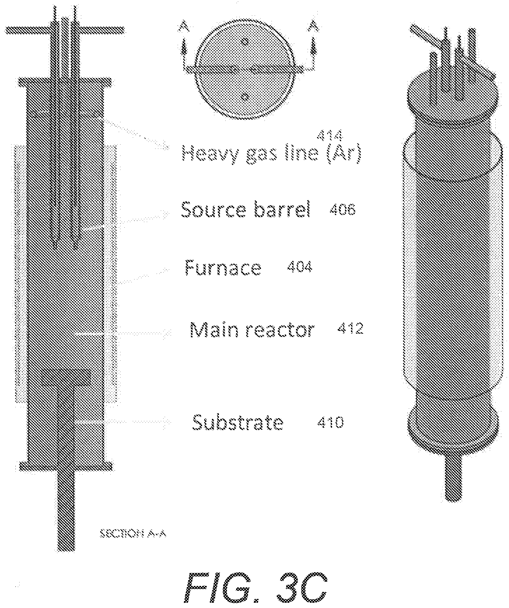

Fig. 3C shows a vertical OVPD system 400, according to an exemplary embodiment. OVPD system 400 may include a main reactor 412 defined by a main reactor wall, at least two source barrels 406 configured to introduce at least two organic vapors into the main reactor 42. The OVPD system 400 may also include a substrate 410 stage positioned in the main reactor 412 and at least one carrier gas injection line 414 (also referred to as "heavy gas line") configured to distribute a carrier gas along the main reactor wall. The carrier gas may be configured to reduce condensation of the organic vapors onto the main reactor wall as the organic vapors flow toward the substrate stage 410 by directing all the flow paths of the organic vapors toward the substrate 410. By reducing the likelihood of condensation on the main reactor, furnace 404 of OVPD system 400 may operate at a reduced temperature. For example, furnace 400 may operate at a temperature below the evaporation temperature of the high evaporation temperature vapor. OVPD system may also include heating coils surrounding at least a portion of the source barrels enabling separate independent temperature control over each source barrel 406.

Fig. 3C shows that the at least one carrier gas injection line 414 may be ring shaped and may extend concentrically around the wall of the main reactor 412 such that the additional carrier gas may flow along the wall of the main reactor thereby directing the organic vapors down the center region of the main reactor way from the wall of the main reactor 412. In some embodiments Ar gas may be preferred to N₂ gas due to the heavier mass of Ar gas. As described herein, distributing the carrier gas from carrier gas injection line 414 may keep the organic vapors from the source barrels 406 from hitting the wall of the main reactor 412, thereby prohibiting condensation from forming on the wall even at a relatively low temperature in the main reactor 412 when formation of condensation is usually a concern.

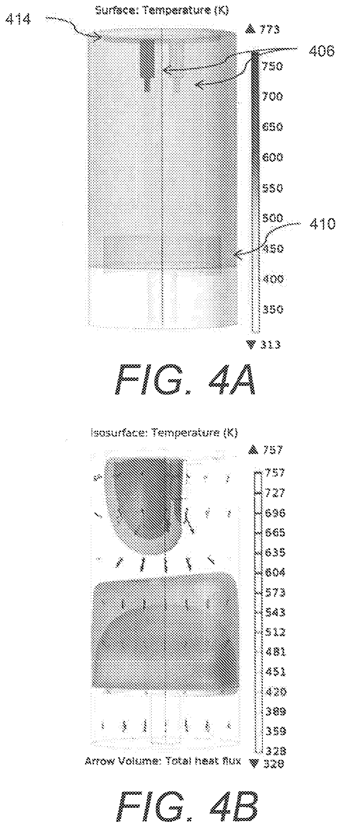

Figs. 4A and 4B show numerical simulations of operation for OVPD system 400 shown in Fig. 3C. For the numerical simulation, the temperature of the LTM, and HTM source barrels were set at 200°C (473 K), and 500°C (773 K) respectively, with the main reactor temperature set at 300°C (573 K). The flow rate for N₂ gas was set for 20 sccm for each source barrel 406, and the additional background carrier gas injection line 414 flow rate was set to 20 sccm of Ar gas and was configured to flow around the perimeter of the main reactor 412. A steady-state model for a compressible Newtonian fluid was used to solve the gas-fluid dynamics by the finite-difference time-domain (FDTD) method. In some embodiments the temperature of the LTM source barrel could be set in the range of 150°C to 250°C. In some embodiments the temperature of the LTM source barrel could be set in the range of 100°C to 300°C. In some embodiments the temperature of the HTM source barrel could be set in the range of 450°C to 550°C. In some embodiments the temperature of the HTM source barrel could be set in the range of 400°C to 600°C. In some embodiments the temperature of the main reactor could be set in the range of 250°C to 350°C. In some embodiments the temperature of the main reactor could be set in the range of 200°C to 400°C. In some embodiments the flow rate for the carrier gas could be set in the range of 15 sccm to 25 sccm for at least one source barrel 406. In some embodiments the flow rate for the carrier gas could be set in the range of 10 sccm to 30 sccm for at least one source barrel 406.

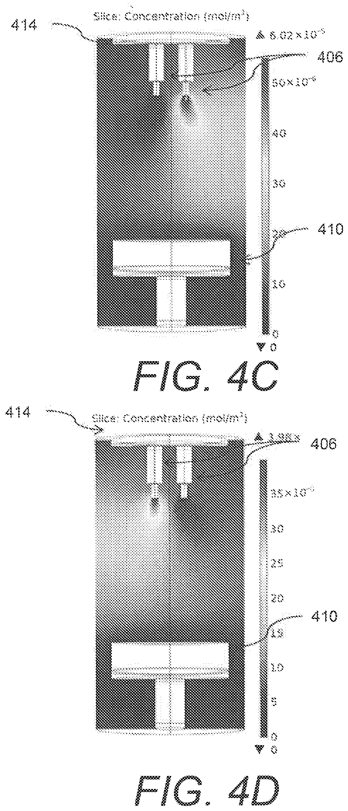

The numerical simulation of Fig. 4A shows the temperature distribution of OVPD system 400 operating at the above parameters. The numerical simulation of Fig. 4B shows the isosurface plot of temperature of OVPD system 400 operating at the above parameters. Arrows in the space indicate the total heat flux. As shown in Fig. 4B, the total heat flux is directed inward towards the cooled-substrate. As shown in Figs. 4C, and 4D, the concentration of each material is the highest at the inlet to the main reactor 412 from the source barrels 406, and is diluted as each material is transported through the N₂ carrier gas towards the substrate. The calculated ratio of total amount of each material deposited on the substrate is about 1.18, indicating a homogeneous mixture of both materials may be achieved by this exemplary design.

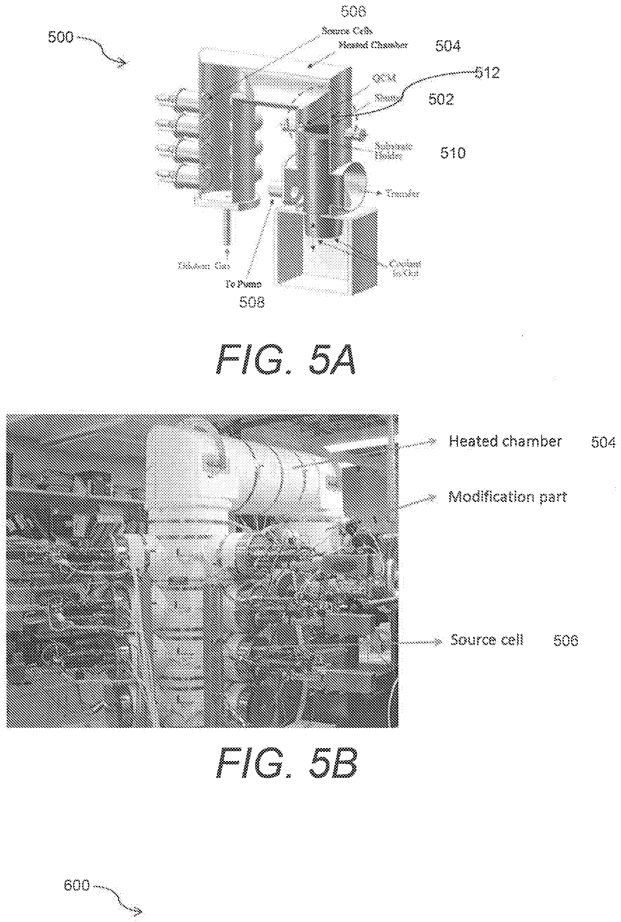

Figs. 5A and 5B show a Gen-6 OVPD system 500 that may be used in large-area device fabrication. The Gen-6 (1.5 m × 1.8m) OVPD system was demonstrated previously for large area device fabrication, and is described in *Organic Vapor Phase Deposition for the Growth of Large Area Organic Electronic Devices* by Lunt *et al*.( R. R. Lunt, B. E. Lassiter, J. B. Benziger, S. R. Forrest. "Organic Vapor Phase Deposition for the Growth of Large Area Organic Electronic Devices" Appl. Phys. Lett., 95, 233305, 2009). The Gen-6 OVPD system is configured to have automated source position inside a stainless-steel main reactor 512, and the substrate stage 510 has an elevator to adjust the height of the substrate depending on the deposition sequence. As shown, the Gen-OVPD system 500 may also include source cells 506, heated chamber 504, and shutter 502.

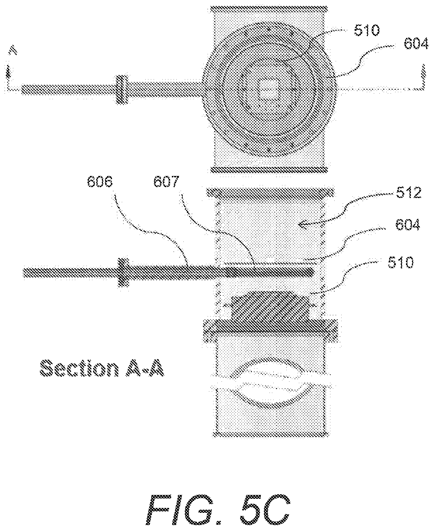

Fig. 5C shows an OVPD system 600, according to an exemplary embodiment, which may include a modified main reactor chamber. The OVPD system 600 shown in Fig. 5C may be similar to the Gen-6 OVPD system 500 shown in Figs. 5A and 5B except OVPD system 600 may be modified at the area within the dotted circle shown in Fig. 5A. The modification to OVPD system 600 may include a second source barrel 606 configured to distribute a second organic vapor, which is at a lower temperature than the second organic vapor, into the main reactor 512 through a second source barrel outlet 607, wherein the second source barrel outlet 607 is positioned between the first end of the main reactor 512 and the substrate stage 510 a distance from the substrate, wherein the distance is selected to minimize the exposure of the first organic vapor to the higher temperature of the second organic vapor as the first organic vapor travels toward the substrate stage 510. The source barrel outlet 607 may be shower-head ring shaped and configured to distribute the second organic vapor toward the substrate 510. System 600 may also include an insulating plate 604 positioned on the opposite side of the second source barrel outlet 607 than the substrate stage 510, in order to reduce the amount of first organic vapor (e.g., LTM vapor) colliding with the hot shower-head ring shaped outlet 607. The hot shower-head ring shaped outlet 607 may be configured with multiple holes around its perimeter to blow HTM vapor on the substrate 510.

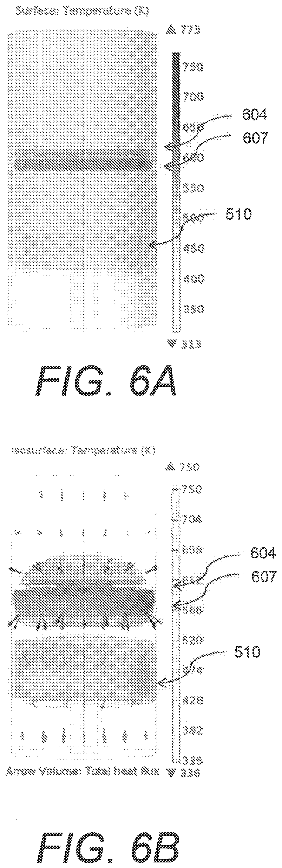

Figs. 6A 6B, 6C, and 6D show numerical simulations of OVPD system 600 shown in Fig. 5C. For the numerical simulation, the temperature of the HTM source barrel, which is configured like a shower-head, is set to 500°C (773 K). In some embodiments the temperature of the HTM source barrel could be set in the range of 450°C to 550°C. In some embodiments the temperature of the HTM source barrel could be set in the range of 400°C to 600°C. For the numerical simulation, the temperature of the main tube was set at 200°C (473K), which is appropriate for LTM flux from the source barrels 506, and the substrate 510 temperature was set at 30°C (303 K). In some embodiments the temperature of the main reactor could be set in the range of 150°C to 250°C. In some embodiments the temperature of the main reactor could be set in the range of 100°C to 300°C. In some embodiments the temperature of the LTM source barrel could be set in the range of 150°C to 250°C. In some embodiments the temperature of the LTM source barrel could be set in the range of 100°C to 300°C. In some embodiments the temperature of the substrate could be set in the range of 25°C to 35°C. In some embodiments the temperature of the substrate could be set in the range of 20°C to 30°C. For the numerical simulation, the flow rate of N₂ from the shower-head 607 was set to 20 sccm. In some embodiments the flow rate for the carrier gas could be set in the range of 15 sccm to 25 sccm for at least one source barrel. In some embodiments the flow rate for the carrier gas could be set in the range of 10 sccm to 30 sccm for at least one source barrel. For the numerical simulation, the total N₂ gas flow from the source cells (including dilution line in the chamber) was 80 sccm. In some embodiments the total N₂ gas flow from the source cells could be set in the range of 70 sccm to 90 sccm. In some embodiments the total N₂ gas flow from the source cells could be set in the range of 60 sccm to 100 sccm. In some embodiments the total N₂ gas flow from the source cells could not include a dilution line in the chamber and the total N₂ gas flow could be set in a range of 20 sccm to 60 sccm.

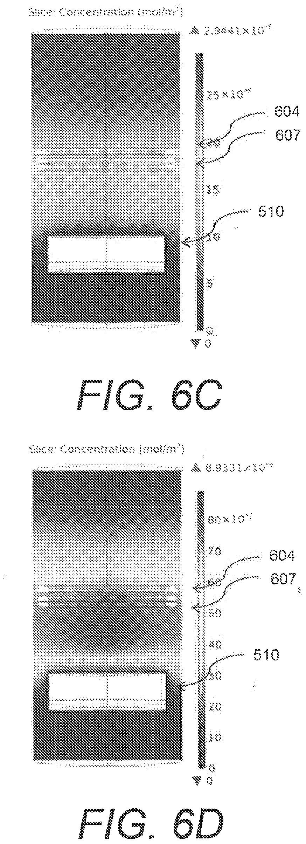

As shown in Fig. 6B, a large temperature difference exists between the hot shower-head 607 and the cooled-substrate 510, which induces a strong heat flux from the shower-head to the substrate. The LTM concentration plot in Fig. 6C shows the LTM flux from the top of the main reactor 512 approaches the entrance of the shower-head 607, condensing on the substrate 510. Similarly, injected HTM flux from the shower-head 607 is diluted as the HTM approaches the substrate 510, as shown in Fig. 6D.

An embodiment of the present disclosure may also include a method of utilizing OVPD system 600 to fabricate an organic film. The method may include introducing a first organic vapor at a first temperature into a first end of a main reactor and directing the first organic vapor toward a substrate positioned at a second end of the main reactor. The method may also include introducing a second organic vapor at a second temperature, which may be greater than the first temperature, into the main reactor toward the substrate, wherein the second organic vapor may be introduced into the main reactor between the first end of the main reactor and the substrate a distance from the substrate. The distance may be selected to minimize the exposure of the first organic vapor to the higher temperature of the second organic vapor as the first organic vapor travels toward the substrate.

Other embodiments of the present disclosure will be apparent to those skilled in the art from consideration of the specification and practice of the present disclosure herein. It is intended that the specification and examples be considered as exemplary only, with a true scope of the present disclosure being indicated by the following claims.

## Claims

1. An organic vapor phase deposition system comprising:
a main reactor defined by a main reactor wall;
at least two source barrels configured to introduce at least two organic vapors into the main reactor;
a substrate stage positioned in the main reactor; and
at least one carrier gas injection line configured to distribute a carrier gas along the main reactor wall, which reduces condensation of the organic vapors onto the main reactor wall as the organic vapors flow toward the substrate stage;
wherein the at least one carrier gas injection line is ring shaped and extends concentric to the main reactor wall.

2. The system of claim 1, wherein the temperature of the at least two source barrels are independently controlled.

3. The system of claim 2, wherein the temperature of the at least two source barrels are controlled by heating coils surrounding at least a portion of the source barrels.

4. The system of claim 1, wherein
the at least one carrier gas injection line discharges a carrier gas, which includes at least one of Argon gas and Nitrogen gas.

5. The system of claim 1, wherein one of the source barrels is configured to be controlled to a temperature of about 200°C and another one of the source barrels is configured to be controlled to a temperature of about 500°C while the main reactor is configured to be controlled to a temperature of about 300°C, or
wherein the organic vapors are introduced into the main reactor at about 20 sccm while the carrier gas is distributed into the main reactor at about 20 sccm.

6. The system of claim 1, wherein the at least one carrier gas injection line begins distributing the carrier gas along the main reactor wall above where the two organic vapors are introduced into the main reactor, or
wherein the system is configured in a vertical orientation where the organic vapors are introduced into the main reactor above the substrate stage.

7. An organic vapor phase deposition system comprising:
a main reactor;
a first source barrel configured to introduce a first organic vapor into a first end of the main reactor;
a substrate stage positioned at a second end of the main reactor; and
a second source barrel configured to distribute a second organic vapor, which is at a higher temperature than the first organic vapor, into the main reactor through a second source barrel outlet;
wherein the second source barrel outlet is positioned between the first end of the main reactor and the substrate stage a distance from the substrate, wherein the distance is selected to minimize the exposure of the first organic vapor to the higher temperature of the second organic vapor as the first organic vapor travels toward the substrate stage.

8. The system of claim 7, wherein the second source barrel outlet is shower-head ring shaped and configured to distribute the second organic vapor toward the substrate.

9. The system of claim 7, further comprising an insulating plate configured to reduce the amount of the first organic vapor that contacts the second source barrel outlet, wherein the second source barrel outlet is positioned between the insulating plate and the substrate stage.

10. The system of claim 7, wherein the first organic vapor is configured to be introduced into the main reactor at a temperature of about 200°C and the second organic vapor is configured to be distributed into the main reactor at a temperature of about 500°C while a substrate on the substrate stage is at a temperature of about 30°C.

11. A method of fabricating an organic film using organic vapor phase deposition, comprising the steps of:
introducing a first organic vapor at a first temperature into a main reactor defined by a perimeter wall;
introducing a second organic vapor at a second temperature, which is greater than the first temperature, into the main reactor; and
distributing a carrier gas into the main reactor along an inner surface of the perimeter wall;
wherein the carrier gas is configured to reduce condensation of the second organic vapor on the perimeter wall as the first organic vapor and the second organic vapor flow through the main reactor toward a substrate.

12. The method of claim 11, wherein the first temperature is about 200°C, the second temperature is about 500°C, and a main reactor temperature is about 300°C.

13. The method of claim 11, further comprising independently controlling the first organic vapor to the first temperature and the second organic vapor to the second temperature using heating coils surrounding a first source barrel and a second source barrel.

14. The method of claim 11, wherein the carrier gas includes at least one of Argon gas and Nitrogen gas, or
wherein the first organic vapor and the second organic vapor are each introduced into the main reactor at about 20 sccm while the carrier gas is distributed into the main reactor at about 20 sccm or
wherein distributing the carrier gas begins above where the first organic vapor and the second organic vapor are introduced into the main reactor or
wherein the carrier gas is distributed from a ring that extends around the main reactor.

15. A method of fabricating an organic film using organic vapor phase deposition, comprising the steps of:
introducing a first organic vapor at a first temperature into a first end of a main reactor and directing the first organic vapor toward a substrate positioned at a second end of the main reactor; and
introducing a second organic vapor at a second temperature, which is greater than the first temperature, into the main reactor toward the substrate;
wherein the second organic vapor is introduced into the main reactor between the first end of the main reactor and the substrate a distance from the substrate, wherein the distance is selected to minimize the exposure of the first organic vapor to the higher temperature of the second organic vapor as the first organic vapor travels toward the substrate.

## Patentansprüche

1. System zur organischen Dampfphasenabscheidung, umfassend:
einen Hauptreaktor, der durch eine Hauptreaktorwand definiert ist;
mindestens zwei Quellenrohre, die konfiguriert sind, um mindestens zwei organische Dämpfe in den Hauptreaktor einzuleiten;
eine Substratstufe, die im Hauptreaktor positioniert ist; und
mindestens eine Trägergasinjektionsleitung, die konfiguriert ist, um ein Trägergas entlang der Hauptreaktorwand zu verteilen, was die Kondensation der organischen Dämpfe auf der Hauptreaktorwand verringert, wenn die organischen Dämpfe zur Substratstufe hin strömen;
wobei die mindestens eine Trägergasinjektionsleitung ringförmig ist und sich konzentrisch zur Hauptreaktorwand erstreckt.

2. System nach Anspruch 1, wobei die Temperatur der mindestens zwei Quellenrohre selbständig geregelt wird.

3. System nach Anspruch 2, wobei die Temperatur der mindestens zwei Quellenrohre durch Heizschlangen geregelt wird, die mindestens einen Teil der Quellenrohre umgeben.

4. System nach Anspruch 1, wobei
die mindestens eine Trägergasinjektionsleitung ein Trägergas abgibt, das mindestens eines von Argongas und Stickstoffgas enthält.

5. System nach Anspruch 1, wobei eines der Quellenrohre konfiguriert ist, um auf eine Temperatur von etwa 200 °C geregelt zu werden, und ein anderes der Quellenrohre konfiguriert ist, um auf eine Temperatur von etwa 500 °C geregelt zu werden, wohingegen der Hauptreaktor konfiguriert ist, um auf eine Temperatur von etwa 300 °C geregelt zu werden, oder
wobei die organischen Dämpfe mit etwa 20 sccm in den Hauptreaktor eingeleitet werden, während das Trägergas mit etwa 20 sccm in den Hauptreaktor verteilt wird.

6. System nach Anspruch 1, wobei die mindestens eine Trägergasinjektionsleitung beginnt, das Trägergas entlang der Hauptreaktorwand oberhalb der Stelle zu verteilen, an der die zwei organischen Dämpfe in den Hauptreaktor eingeleitet werden, oder
wobei das System in einer vertikalen Ausrichtung konfiguriert ist, wobei die organischen Dämpfe in den Hauptreaktor oberhalb der Substratstufe eingeleitet werden.

7. System zur organischen Dampfphasenabscheidung, umfassend:
ein Hauptreaktor;
ein erstes Quellenrohr, das konfiguriert ist, um einen ersten organischen Dampf in ein erstes Ende des Hauptreaktors einzuleiten;
eine Substratstufe, die an einem zweiten Ende des Hauptreaktors positioniert ist; und
ein zweites Quellenrohr, das konfiguriert ist, um einen zweiten organischen Dampf, der eine höhere Temperatur als der erste organische Dampf hat, durch einen Auslass des zweiten Quellenrohres in den Hauptreaktor zu verteilen;
wobei der Auslass des zweite Quellenrohres zwischen dem ersten Ende des Hauptreaktors und der Substratstufe in einem Abstand von dem Substrat positioniert ist, wobei der Abstand ausgewählt ist, um das Ausgesetztsein des ersten organischen Dampfs gegenüber der höheren Temperatur des zweiten organischen Dampfs zu minimieren, wenn der erste organische Dampf zur Substratstufe hin wandert.

8. System nach Anspruch 7, wobei der Auslass des zweiten Quellenrohres brausekopfringförmig ist und konfiguriert ist, um den zweiten organischen Dampf zum Substrat hin zu verteilen.

9. System nach Anspruch 7, ferner umfassend eine isolierende Platte, die konfiguriert ist, um die Menge des ersten organischen Dampfs zu verringern, der mit dem Auslass des zweiten Quellenrohres in Kontakt kommt, wobei der Auslass des zweiten Quellenrohres zwischen der isolierenden Platte und der Substratstufe positioniert ist.

10. System nach Anspruch 7, wobei der erste organische Dampf konfiguriert ist, um in den Hauptreaktor bei einer Temperatur von etwa 200 °C eingeleitet zu werden, und der zweite organische Dampf konfiguriert ist, um in den Hauptreaktor bei einer Temperatur von etwa 500 °C verteilt zu werden, während ein Substrat auf der Substratstufe eine Temperatur von etwa 30 °C hat.

11. Verfahren zum Herstellen einer organischen Folie unter Verwendung einer organischen Dampfphasenabscheidung, umfassend die Schritte:
Einleiten eines ersten organischen Dampfes bei einer ersten Temperatur in einen Hauptreaktor, der durch eine Umfangswand definiert ist;
Einleiten eines zweiten organischen Dampfes bei einer zweiten Temperatur, die höher als die erste Temperatur ist, in den Hauptreaktor; und
Verteilen eines Trägergases in den Hauptreaktor entlang einer Innenfläche der Umfangswand;
wobei das Trägergas konfiguriert ist, um die Kondensation des zweiten organischen Dampfs an der Umfangswand zu verringern, wenn der erste organische Dampf und der zweite organische Dampf durch den Hauptreaktor zu einem Substrat hin strömen.

12. Verfahren nach Anspruch 11, wobei die erste Temperatur etwa 200 °C beträgt, die zweite Temperatur etwa 500°C beträgt und eine Hauptreaktortemperatur etwa 300 °C beträgt.

13. Verfahren nach Anspruch 11, ferner umfassend das selbständige Regeln des ersten organischen Dampfs auf die erste Temperatur und des zweiten organischen Dampfs auf die zweite Temperatur unter Verwendung von Heizschlangen, die ein erstes Quellenrohr und ein zweites Quellenrohr umgeben.

14. Verfahren nach Anspruch 11, wobei das Trägergas mindestens eines von Argongas und Stickstoffgas enthält, oder
wobei der erste organische Dampf und der zweite organische Dampf jeweils mit etwa 20 sccm in den Hauptreaktor eingeleitet werden, während das Trägergas mit etwa 20 sccm in den Hauptreaktor verteilt wird, oder
wobei das Verteilen des Trägergases oberhalb der Stelle beginnt, an der der erste organische Dampf und der zweite organischen Dampfes in den Hauptreaktor eingeleitet werden, oder
wobei das Trägergas von einem Ring verteilt wird, der sich um den Hauptreaktor erstreckt.

15. Verfahren zum Herstellen einer organischen Folie unter Verwendung einer organischen Dampfphasenabscheidung, umfassend die Schritte:
Einleiten eines ersten organischen Dampfs bei einer ersten Temperatur in ein erstes Ende eines Hauptreaktors und Leiten des ersten organischen Dampfs zu einem Substrat hin, das an einem zweiten Ende des Hauptreaktors positioniert ist; und
Einleiten eines zweiten organischen Dampfes bei einer zweiten Temperatur, die höher als die erste Temperatur ist, in den Hauptreaktor zum Substrat hin;
wobei der zweite organische Dampf in den Hauptreaktor zwischen dem ersten Ende des Hauptreaktors und dem Substrat in einem Abstand von dem Substrat eingeleitet wird, wobei der Abstand ausgewählt ist, um das Ausgesetztsein des ersten organischen Dampfs gegenüber der höheren Temperatur des zweiten organischen Dampfs zu minimieren, wenn der erste organische Dampf zum Substrat hin wandert.

## Revendications

1. Système de dépôt en phase vapeur organique comprenant :
un réacteur principal défini par une paroi de réacteur principal ;
au moins deux cylindres source configurés pour introduire au moins deux vapeurs organiques dans le réacteur principal ;
un étage de substrat positionné dans le réacteur principal ; et
au moins une conduite d'injection de gaz porteur configurée pour distribuer un gaz porteur le long de la paroi de réacteur principal, ce qui réduit la condensation des vapeurs organiques sur la paroi de réacteur principal tandis que les vapeurs organiques s'écoulent vers l'étage de substrat ;
dans lequel l'au moins une conduite d'injection de gaz porteur est en forme d'anneau et s'étend concentriquement à la paroi de réacteur principal.

2. Système selon la revendication 1, dans lequel la température des au moins deux cylindres source est commandée indépendamment.

3. Système selon la revendication 2, dans lequel la température des au moins deux cylindres source est commandée par des serpentins chauffants entourant au moins une partie des cylindres source.

4. Système selon la revendication 1, dans lequel
l'au moins une conduite d'injection de gaz porteur décharge un gaz porteur, qui comprend au moins l'un du gaz argon et du gaz azote.

5. Système selon la revendication 1, dans lequel l'un des cylindres source est configuré pour être commandé à une température d'environ 200°C et un autre des cylindres source est configuré pour être commandé à une température d'environ 500°C tandis que le réacteur principal est configuré pour être commandé à une température d'environ 300°C, ou
dans lequel les vapeurs organiques sont introduites dans le réacteur principal à environ 20 sccm tandis que le gaz porteur est distribué dans le réacteur principal à environ 20 sccm.

6. Système selon la revendication 1, dans lequel l'au moins une conduite d'injection de gaz porteur commence à distribuer le gaz porteur le long de la paroi de réacteur principal au-dessus de l'endroit où les deux vapeurs organiques sont introduites dans le réacteur principal, ou
dans lequel le système est configuré dans une orientation verticale où les vapeurs organiques sont introduites dans le réacteur principal au-dessus de l'étage de substrat.

7. Système de dépôt en phase vapeur organique comprenant :
un réacteur principal ;
un premier cylindre source configuré pour introduire une première vapeur organique dans une première extrémité du réacteur principal ;
un étage de substrat positionné à une seconde extrémité du réacteur principal ; et
un deuxième cylindre source configuré pour distribuer une deuxième vapeur organique, qui est à une température plus élevée que la première vapeur organique, dans le réacteur principal via une seconde sortie de cylindre source ;
dans lequel la seconde sortie de cylindre source est positionnée entre la première extrémité du réacteur principal et l'étage de substrat à une distance du substrat, dans lequel la distance est choisie pour minimiser l'exposition de la première vapeur organique à la température plus élevée de la deuxième vapeur organique tandis que la première vapeur organique se dirige vers l'étage de substrat.

8. Système selon la revendication 7, dans lequel la seconde sortie de cylindre source est en forme d'anneau de pomme de douche et configurée pour distribuer la deuxième vapeur organique vers le substrat.

9. Système selon la revendication 7, comprenant en outre une plaque isolante configurée pour réduire la quantité de la première vapeur organique qui entre en contact avec la seconde sortie de cylindre source, dans lequel la seconde sortie de cylindre source est positionnée entre la plaque isolante et l'étage de substrat.

10. Système selon la revendication 7, dans lequel la première vapeur organique est configurée pour être introduite dans le réacteur principal à une température d'environ 200°C et la deuxième vapeur organique est configurée pour être distribuée dans le réacteur principal à une température d'environ 500°C tandis qu'un substrat sur l'étage de substrat est à une température d'environ 30°C.

11. Procédé de fabrication d'un film organique utilisant un dépôt en phase vapeur organique, comprenant les étapes de :
introduction d'une première vapeur organique à une première température dans un réacteur principal défini par une paroi périphérique ;
introduction d'une deuxième vapeur organique à une deuxième température, supérieure à la première température, dans le réacteur principal ; et
distribution d'un gaz porteur dans le réacteur principal le long d'une surface interne de la paroi périphérique ;
dans lequel le gaz porteur est configuré pour réduire la condensation de la deuxième vapeur organique sur la paroi périphérique tandis que la première vapeur organique et la deuxième vapeur organique s'écoulent à travers le réacteur principal vers un substrat.

12. Procédé selon la revendication 11, dans lequel la première température est d'environ 200°C, la deuxième température est d'environ 500°C et une température du réacteur principal est d'environ 300°C.

13. Procédé selon la revendication 11, comprenant en outre la commande indépendante de la première vapeur organique à la première température et de la deuxième vapeur organique à la deuxième température en utilisant des serpentins chauffants entourant un premier cylindre source et un deuxième cylindre source.

14. Procédé selon la revendication 11, dans lequel le gaz porteur comprend au moins l'un parmi le gaz argon et le gaz azote, ou
dans lequel la première vapeur organique et la deuxième vapeur organique sont chacune introduites dans le réacteur principal à environ 20 sccm tandis que le gaz porteur est distribué dans le réacteur principal à environ 20 sccm ou
dans lequel la distribution du gaz porteur commence au-dessus de l'endroit où la première vapeur organique et la deuxième vapeur organique sont introduites dans le réacteur principal ou
dans lequel le gaz porteur est distribué à partir d'un anneau qui s'étend autour du réacteur principal.

15. Procédé de fabrication d'un film organique utilisant un dépôt en phase vapeur organique, comprenant les étapes de :
introduction d'une première vapeur organique à une première température dans une première extrémité d'un réacteur principal et direction de la première vapeur organique vers un substrat positionné à une seconde extrémité du réacteur principal ; et
introduction d'une deuxième vapeur organique à une deuxième température, qui est supérieure à la première température, dans le réacteur principal vers le substrat ;
dans lequel la deuxième vapeur organique est introduite dans le réacteur principal entre la première extrémité du réacteur principal et le substrat à une distance du substrat, dans lequel la distance est choisie pour minimiser l'exposition de la première vapeur organique à la température plus élevée de la deuxième vapeur organique tandis que la première vapeur organique se déplace vers le substrat.
